# EUROPÄISCHE PATENTSCHRIFT

(11) **EP 0 712 267 B1**
(45) Veröffentlichungstag und Bekanntmachung des Hinweises auf die Patenterteilung: **31.10.2001**
(21) Anmeldenummer: 95113951.8
(22) Anmeldetag: 06.09.1995
(51) Int. Cl.: H05K 7/14, H01R 9/26

(54) **Modulare Steuerungsanlage mit integriertem Feldbusanschluss**
Modular control equipment with field bus integrated connection
Installation de commande modulaire avec connexion sur bus secteur intégré

(30) Priorität: 10.11.1994 DE 4440102
(43) Veröffentlichungstag der Anmeldung: 15.05.1996
(73) Patentinhaber: Weidmüller Interface GmbH & Co., 32760 Detmold (DE)
(72) Erfinder: Glathe, Hans-Georg, D-32758 Detold (DE); Schnatwinkel, Michael, D-32051 Herfold (DE); Zebermann, Christoph, Dr., D-37688 Beverungen (DE)
(74) Vertreter: Stracke, Alexander, Dipl.-Ing.

(56) Entgegenhaltungen:
- DE-A- 4 033 969
- DE-A- 4 303 717
- FR-A- 2 223 937

## Beschreibung

Die Erfindung betrifft eine modulare Steuerungsanlage gemäß Hauptanspruch 1.

Es sind modulare Steuerungsanlagen der gattungsgemäßen Art bekannt, bei denen in einem Anschlußblock eine Reihe von Anschlußmöglichkeiten für Initiatoren, Aktoren, Feldgeräten od. dgl. bestehen, wobei innerhalb des Anschlußblockes die parallel anliegenden Einzelsignale mittels einer Anpaßelektronik in ein serielles Format umgewandelt werden, das mittels eines Feldbussystems z. B. an eine nachgeordnete Auswerteeinheit übermittelt werden kann. Dabei sind sowohl die Eingabe-/ Ausgabebaugruppen zum Anschluß der Signalleiter und der Versorgungsleiter der zugeordneten Initiatoren, Aktoren, Feldgeräte od. dgl. in einem Gehäuse mit der Anpaßelektronik zur Umsetzung der Signale auf das Feldbusformat angeordnet. Der Anschluß des Feldbusses bzw. der mindestens zwei Feldbuskabel bei einer Einschleifung eines derartigen Anschlußblockes innerhalb eines Feldbussystems erfolgt dabei mittels eines externen, auf den Anschlußblock aufsteckbaren Anpaßsteckers. In diesen Anpaßstecker werden die Feldbusanschlußkabel mittels Direktverdrahtung eingesteckt, so daß die Feldbusanschlußkabel nur über einen derartigen Anpaßstecker an den Anschlußblock anschließbar sind. Innerhalb des Anpaßsteckers ist recht aufwendige Schaltungstechnik erforderlich, um den Anpaßstecker für die jeweilige Betriebsart des Feldbusanschlußes zu konfigurieren, die sich aus der Anschlußmöglichkeit mitten in einem Feldbusabschnitt mit je einem hereinkommenden und einem herausgehenden Kabel bzw. einem Anschluß am Ende eines Feldbusses mit nur einem hereinkommenden Kabel ergibt. Hierzu ist neben den eigentlichen Anschlußelementen zur mechanischen und elektrischen Verbindung der Feldbusanschlußkabel eine Schaltungsanordnung erforderlich, die im Falle eines Betriebes des Anschlußblockes am Ende eines Feldbusses für die Realisierung eines Abschlußwiderstandes genutzt werden kann. Ein derartiger Abschlußwiderstand ist z. B. erforderlich, um unerwünschte Signalreflexionen am Ende des Feldbuskabels zu vermeiden. Da innerhalb des Anpaßsteckers eine Umstellmöglichkeit zwischen den beiden Betriebsarten vorgesehen werden muß, sind Schaltelemente, vorzugsweise in Form von DIP-(Dual-in-line package) Schaltern vorgesehen. Ein derartiger Anpaßstecker ist mit seiner komplexen Funktionsweise eigentlich nur für den Abschluß eines Feldbussystems an dem jeweiligen Anschlußblock erforderlich, so daß in allen anderen Fällen der zu betreibende Schaltungsaufwand gar nicht notwendig ist. Hierdurch werden derartige Anpaßstecker teuer, wobei zwangsläufig durch die nicht bestehende Direktanschlußmöglichkeit der Feldbuskabel an dem Anschlußblock eine Notwendigkeit zur Beschaffung eines derartigen Anpaßsteckers für jeden Anschlußblock besteht.

Eine zweite Funktionalität des vorgestellten Anpaßsteckers besteht darin, daß auch nach Abziehen des Anpaßsteckers von dem Anschlußblock durch die interne Verschaltung des hereinkommenden mit dem herausgehenden Feldbuskabels ein störungsfreier Betrieb der restlichen, an dem Feldbuskabel angeordneten Komponenten eines Steuerungssystems in Form einer sogenannten T-Stück-Funktion ermöglicht wird. Für diese sogen. T-Stück-Funktion des Anpaßsteckers müssen die DIP-Schalter in eine andere Schaltstellung gebracht werden, wozu ein Eingriff in das Innenleben des Schalters notwendig ist. Die T-Stück-Funktion wird durch ein einfaches Brücken der zugeordneten Schalter der Feldbusanschlußkabel erreicht. Hierzu ist ebenfalls der Schaltungsaufwand des Anpaßsteckers gar nicht erforderlich.

Es ist darüber hinaus in früheren Anmeldungen der Anmelderin vorgeschlagen, eine Steuerungsanlage derart modular aufzubauen, daß jeder Anschlußblock sich aus einer Anzahl anreihbarer Anschlußscheiben zusammensetzt, in denen jeweils darin angeordnete Versorgungsanschlüsse und/oder Signalleiteranschlüsse für zugeordnete Initiatoren, Aktoren, Feldgeräte od. dgl. vorgesehen sind. Weiterhin ist gemäß dieses Vorschlages ein getrennter Elektronikmodul bekannt, der zur Signalver- und -bearbeitung dient und eine Verbindung zwischen den Signalleiteranschlüssen und einem internen Busleiter bildet, der mehrere aneinanderanreihbare Anschlußblocks elektrisch miteinander verbindet. Für ein derartiges modulares Steuerungssystem wurde ein separates Feldbusanschlußmodul vorgeschlagen, das für eine Reihung von Anschlußblocks den Anschluß an ein übergeordnetes Feldbussystem realisiert. Hierbei ist neben dem erhöhten Platzbedarf die Notwendigkeit zusätzlicher Komponenten für den Feldbusanschlußmodul gegeben, die eine Verteuerung aufgrund des hierzu erforderlichen Bauaufwandes bedeutet; (vgl. auch DE-A-4 303 717).

Aufgabe der vorliegenden Erfindung ist es daher, für eine modulare Steuerungsanlage der gattungsgemäßen Art eine Möglichkeit zum Anschluß der Feldbuskabel an einen oder mehrere Anschlußblocks zu schaffen, bei dem mit einer einfachen Konfigurationsmöglichkeit bei einem geringen Schaltungsaufwand und ohne Eingriff in die Schaltungselektronik eine Anschlußmöglichkeit für Feldbuskabel geschaffen wird, die auch bei Trennung des Elektronikmoduls von einem Anschlußblock die Funktionsweise der restlichen an dem Feldbus angeordneten Komponenten nicht beeinträchtigt und gleichzeitig ohne aufwendige Änderungen am Aufbau eines Anschlußblockes möglich ist.

Die Lösung der erfindungsgemäßen Aufgabe ergibt sich aus den Merkmalen des Anspruches 1.

Erfindungswesentliches Merkmal der vorgeschlagenen Lösung ist es, daß an einer modularen Steuerungsanlage der gattungsgemäßen Art vorhandene Anschlußmöglichkeiten für einen Direktanschluß der Feldbuskabel in der Form genutzt werden, daß eine Anzahl von eigentlich zum Signalleiteranschluß dienenden Anschlußelementen eines Anschlußblockes für die elektrische und mechanische Verbindung mit Feldbuskabeln genutzt werden. Auch die Verschaltung der Feldbuskabel entweder in Form eines Weiterverbindungselementes mittels T-Stück-Funktion oder in Form eines Abschlußelementes erfolgt durch ohnehin an dem Anschlußblock vorhandene Einrichtungen, indem in derartige Steckplätze funktionsverschiedene Verbindungselemente einsteckbar sind, wobei die Verbindungselemente je nach Einordnung des Anschlußblockes in den Feldbus elektrische Potentiale von Feldbuskabel und Anschlußblock entweder als Abschlußeinheit oder als Weiterverbindungseinheit miteinander verbinden. Darüber hinaus wird die für die Signalanpassung notwendige Anpaßelektronik in den ebenfalls an der modularen Steuerungsanlage vorhandenen Elektronikmodul integriert, so daß nur dieser ohnehin applikationsspezifisch anzupassende Elektronikmodul eine weitere Funktionsbaugruppe zur Feldbusanpassung aufweisen muß.

Die Trennung von physikalischem Anschluß der Feldbuskabel und der notwendigen Verschaltung der Leiter der Feldbuskabel entweder in T-Stück-Funktion zum einen mit dem Elektronikmodul und zum anderen der Leiter untereinander oder der Verschaltung als Abschlußelement des Feldbuskabels erlaubt es, ohne aufwendige Eingriffe in eine vorgegebene Schaltung oder Elektronik den Feldbus entsprechend der jeweils gewünschten Konfiguration anzuschließen. Im Zusammenwirken mit den unterschiedlichen Kombinationsmöglichkeiten und Anordnungsmöglichkeiten des scheibenförmigen Aufbaus der Anschlußblocks ist damit eine äußerst kompakte Bauweise erzielbar, die auf geringem Raum eine hohe Anzahl von Anschlußmöglichkeiten für Initiatoren, Aktoren, Feldgeräte od. dgl. erlaubt und gleichzeitig den Anschluß und die Anpassung der Feldbuskabel realisiert. Weitere erfindungsgemäße Vorteile zeigen die Unteransprüche.

Entsprechend der Standardisierung werden für einen Feldbusanschluß üblicherweise elektrische Potentiale für eine Funktionserde oder Schutzerde zum Anschluß der Schirmerde der Feldbuskabel, zwei Datenleitungen eines einkommenden ersten Feldbuskabels, zwei Datenleitungen eines herausgehenden zweiten Feldbuskabels sowie eine Spannungsversorgung und ein Bezugsleiter, vorzugsweise aus dem -Elektronikmodul kommend, für den Busabschluß. Wird in der erfindungsgemäßen Weise ein Abschlußelement zum Abschluß eines Feldbuskabels für den Anschluß des Feldbusses an den Anschlußblock benötigt, so werden zwischen einzelnen der Datenleitungen der Feldbuskabel elektrische Widerstandselemente geschaltet, die eine Signalreflexion verhindern. Hierbei wird vorzugsweise jeweils ein Widerstandselement zwischen die Spannungsversorgung aus der Elektronik kommend und einen ersten Leiter des ersten Feldbuskabels, einen ersten Leiter des zweiten Feldbuskabels und einen zweiten Leiter des ersten Feldbuskabels sowie einen zweiten Leiter des zweiten Feldbuskabels und den Bezugsleiter bzw. aus der Elektronik kommend geschaltet. Der erste Leiter des ersten Feldbuskabels und der erste Leiter des zweiten Feldbuskabels sowie der zweite Leiter des ersten Feldbuskabels und der zweite Leiter des zweiten Feldbuskabels sind direkt elektrisch leitend verbunden.

In einer zweiten bevorzugten Ausführungsform wird eine wie vorstehend beschriebene Anordnung der Widerstandselemente sowie eine Direktkontaktierung der Leiter der Feldbuskabel vorgenommen, wobei zusätzlich Anschlußmöglichkeiten an Schirmerde/ Folien eine Funktionserde direkt elektrisch leitend miteinander verbunden sind.

Wird beim Einschleifen eines Anschlußblockes in ein Feldbussystem eine Weiterverbindungseinheit benötigt, so wird eine T-stückartige Verbindung zwischen dem ersten Leiter des ersten Feldbuskabels und dem ersten Leiter des zweiten Feldbuskabels sowie dem zweiten Leiter des ersten Feldbuskabels und dem zweiten Leiter des zweiten Feldbuskabels sowie dem Elektronikmodul hergestellt.

Die Anschlüsse von Versorgungsspannung und Bezugsleiter für den Feldbusabschluß werden aus dem Verteilungsbereich des Anschlußblockes aus der Elektronik zur Verfügung gestellt.

In einer weiteren bevorzugten Ausführungsform werden die Verbindungselemente derart den Steckplätzen zugeordnet, daß alle Verbindungselemente innerhalb einer Kontaktierungsebene angeordnet werden können, ohne das Kreuzungen zwischen den einzelnen Kontaktierungsbereichen auftreten. Dies erfolgt in einer bevorzugten Ausführungsform dadurch, daß die Verbindungselement in der Reihenfolge Spannungsversorgung, erster Leiter des ersten Feldbuskabels, erster Leiter des zweiten Feldbuskabels, zweiter Leiter des ersten Feldbuskabels, zweiter Leiter des zweiten Feldbuskabels und Bezugsleiter angeordnet sind. Hierdurch werden immer nur Verbindungen zwischen direkt einander benachbarten elektrischen Potentialen erforderlich, die kreuzungsfrei innerhalb einer Ebene angeordnet werden können.

In einer weiteren bevorzugten Ausführungsform werden die mit den Verbindungselementen verbindbaren Potentiale in der Reihenfolge mindestens eine Funktionserde, Spannungsversorgung, erster Leiter des ersten Feldbuskabels, erster Leiter des zweiten Feldbuskabels, zweiter Leiter des ersten Feldbuskabels, zweiter Leiter des zweiten Feldbuskabels und Neutralleiter angeordnet.

Weicht man von einer derartigen Anordnung ab, so wird in der Regel eine Kontaktierung der einzelnen Potentiale erforderlich, die mindestens in zwei Ebenen erfolgt, um Kreuzungspunkte der einzelnen Verbindungselemente zu verhindern. Dies kann gegebenenfalls in Form einer mehrlagigen Platine od. dgl. erfolgen.

In einer besonderen Ausführungsform der erfindungsgemäßen Lösung werden als Einsteckplätze die an allen Anschlußscheiben vorhandenen, in der bekannten Weise ausgeführten Querverteilersteckplätze genutzt.

Weiterhin ist es durch den internen Busleiter innerhalb einer Reihung von Anschlußblocks möglich, nur einen Feldbusanschluß für eine Anreihung derartiger Anschlußblocks zu nutzen.

Eine bevorzugte Ausführungsform der erfindungsgemäßen modularen Steuerungsanlage zeigt die Zeichnung.

Es zeigen:
- Fig. 1: Beispielhaft einen Prinzipaufbau eines Anschlußblockes aus Anschlußscheiben mit integriertem Bereich zum Feldbusanschluß,
- Fig. 2: den Anschlußblock der Figur 1 in einer perspektivischen Darstellung in einer Konfiguration des Feldbusanschlußbereiches als Weiterverbindungselement,
- Fig. 3: eine perspektivische Darstellung des Anschlußblocks aus Anschlußscheiben der Figur 1 in einer Konfiguration des Feldbusanschlusses als Feldbusabschluß,
- Fig. 4: eine perspektivische Darstellung des Feldbusabschlußsteckers gemäß Figur 1,
- Fig. 5: Prinzipbild der Schaltungsanordnung innerhalb des Feldbusabschlußsteckers, gemäß Figur 4,
- Fig. 6: eine Anschlußscheibe des Anschlußblockes der Figur 1 in einer Seitenansicht im Schnitt,
- Fig. 7: eine andere Beschaltung des Anschlußblockes gemäß Figur 1 unter Erweiterung des Feldbusanschlusses um zwei Steckplätze für eine Funktionserde.

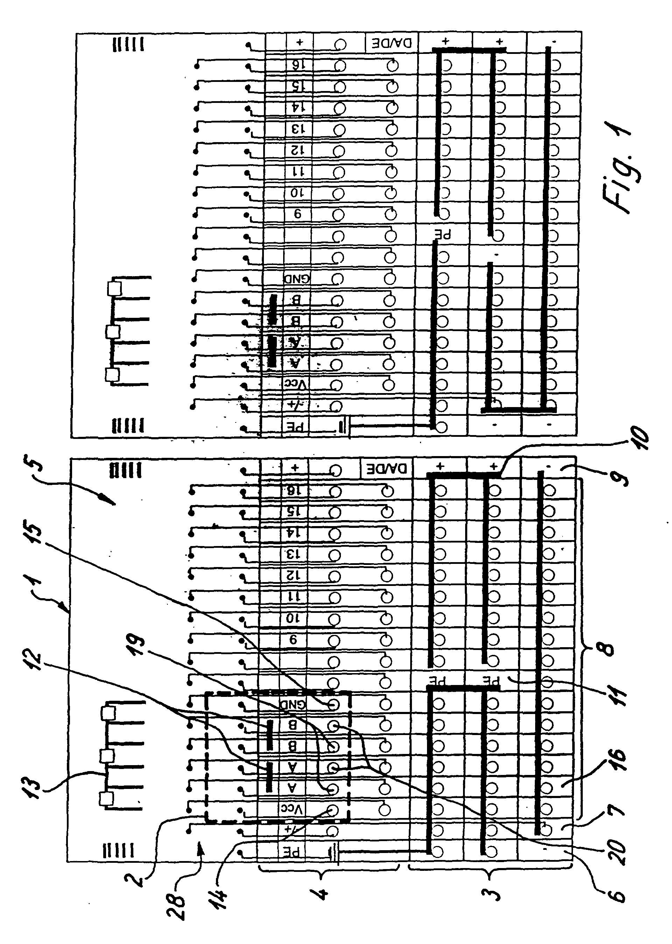

Figur 1 zeigt in einer prinzipiellen Darstellung die Anordnung und Verschaltung der Anschlußscheiben eines Anschlußblockes 1 des erfindungsgemäßen modularen Steuerungssystems, in dem ein Bereich 2 für den Feldbusanschluß, ein Bereich 3 für Verteilerleisten sowie ein Bereich 4 für Signalleiteranschlüsse erkennbar ist. Der Anschlußblock 1 wird in von der Anmelderin vorgeschlagenen Weise aus einer Reihung von einzelnen Anschlußscheiben 6-9 aufgebaut, wobei diese Anschlußscheiben 6-9 funktionsverschieden gestaltet und bestückbar sind und so eine einfache Anpassung weniger Grundbauformen von Anschlußscheiben an verschiedene Aufgaben und Einsatzzwecke ermöglicht. In der Figur 1 besteht die Reihung der Anschlußscheiben vorzugsweise aus einer Schutzleiterscheibe 6, die am Beginn des Anschlußblockes 1 angeordnet und mit einer nicht dargestellten Tragschiene elektrisch und mechanisch verbindbar ist. Daran anschließend ist eine Einspeisescheibe 7 angeordnet, auf der von einer nicht dargestellten externen Spannungsversorgung ein oder mehrere unterschiedliche elektrische Potentiale mittels Kabelverbindung auflegbar sind und die den Ausgangspunkt für die noch später dargestellte Querverteilung innerhalb des Anschlußblockes 1 darstellen. An die Einspeisescheibe 7 schließt sich eine Anzahl von Versorgungs-/ Signalleiterscheiben 8 an, die zum Anschluß nicht dargestellter Initiatoren, Aktoren, Feldgeräte od. dgl. sowohl zur deren elektrischen Versorgung als auch zur Rückmeldung ihrer Signale vorgesehen sind. Daher teilt sich eine Versorgungs-/Signalleiterscheibe 8 in einen Verteilungsbereich 3, an dem die Versorgungsspannungen für die Initiatoren, Aktoren, Feldgeräte od. dgl. abgreifbar sind, und in einen Signalleiterbereich 4, an die deren Signalleiter anschließbar sind. Am Ende eines Anschlußblocks 1 ist eine Rastfußscheibe 9 angeordnet, die neben einer mechanischen Verrastung auf der nicht dargestellten Tragschiene auch zusätzliche elektrische Funktionen, in der Figur 1 z. B. eine weitere Anschlußmöglichkeit eines externen Potentials, ermöglicht.

Der Signalleiterbereich 4 der Anschlußscheiben 6-9 ist mittels Kontaktierungsstegen mit einem Bereich 28 zur Anordnung eines hier nicht dargestellten Elektronikmodules 23 verbindbar, der die Be- und Verarbeitung aller anstehenden Signale übernimmt und diese ausgewerteten Signale an einen ebenfalls nur angedeuteten Bereich 5 für einen internen Busleiter weitergibt, der zur Kommunikation innerhalb einer an einer Tragschiene angeordneten Anzahl von Anschlußblocks 1 dienen kann. Ebenfalls dient dieser Elektronikmodul 23 in der hier vorgestellten bevorzugten Ausführungsform dazu, Signale aus dem Signalleiterbereich 4 nach ihrer Verarbeitung in den Feldbusanschlußbereich 2 weiterzuleiten und dort an den Feldbus anzukoppeln.

Innerhalb des Verteilungsbereiches 3 können elektrische Potentiale durch bekannte Verteilerleisten über die Anschlußscheiben 6-9 eines Anschlußblockes 1 querverteilt werden, so daß eine für die Applikation oder den Bedarf des Anwenders erforderliche Anzahl und Anordnung von Anschlußmöglichkeiten für verschiedenartige Initiatoren, Aktoren, Feldgeräte oder dergleichen innerhalb eines Anschlußblockes 1 möglich ist. Hierbei ist nicht nur eine Querverteilung innerhalb einer Verteilerleiste möglich, sondern es ist mittels Brückenelementen 10 und 11 auch eine Verteilung eines elektrischen Potentials über mehr als eine Verteilerleiste möglich, indem ein derartiges Brückenelement 10, 11 an beliebiger Stelle der Verteilerleiste zwei nebeneinander angeordnete Verteilerleisten elektrisch miteinander verbindet. Ebenfalls ist es möglich, nur einen Teil einer Verteilerleiste mit einem elektrischen Potential zu beaufschlagen, in dem ein Brückenelement 11 innerhalb der Verteilerleiste angereiht wird, das eine weitere Querverteilung des anstehenden elektrischen Potentials innerhalb mindestens einer Verteilerleiste unterbindet. Es besteht bei einem derartigen Brükkenelement oder bei einem hier nicht dargestellten, nur innerhalb einer Verteilerleiste angeordneten Trennelement nur eine elektrische Verbindung einseitig innerhalb der Verteilerleiste. Auf der anderen Seite des entsprechenden Brückenelementes 11 oder Trennelementes kann dann ein weiteres elektrisches Potential mittels einer Verkabelung neu aufgelegt werden.

Innerhalb des Bereiches 2 zum Feldbusanschluß ist in der Figur 1 in einer erfindungsgemäßen Reihenfolge an der dem Busleiterbereich 5 zugewandten Reihe der Signalleiteranschlüsse 4 eine Aneinanderreihung von Anschlußelementen dargestellt, in die zum einen die Spannungsversorgung 14 und der Bezugsleiter 15 aus dem Elektronikmodul für den Busabschluß kommend zur Verfügung gestellt wird und zum anderen die höchstens zwei Feldbusanschlußkabel einsteckbar sind. Alternativ hierzu kann die Spannungsversorgung 14 des Feldbusabschlusses durch Auflegen von externen Potentialen auf die Spannungseinspeisung 14 sowie den Bezugsleiter 15 erreicht werden, die in einer bevorzugten Ausführungsform von den elektrischen Potentialen innerhalb des Verteilungsbereiches 3 abgegriffen werden können. Die beiden Leiter der Spannungsversorgung 14, 15 sind beidseits der Anschlußmöglichkeiten für die Feldbuskabel angeordnet, wobei die Reihung der Leiter der Feldbuskabel in der Reihenfolge: erster Leiter 19 des ersten Feldbuskabels, erster Leiter 20 des zweiten Feldbuskabels, zweiter Leiter 19 des ersten Feldbuskabels, zweiter Leiter 20 des zweiten Feldbuskabels erfolgt. Diese Reihenfolge beim Anschluß der Spannungsversorgung 14, 15 sowie der Feldbuskabel 19, 20 ermöglicht es in einer noch später aufgeführten Weise, besonders einfach Verbindungen zwischen den einzelnen elektrischen Potentialen herzustellen. Grundsätzlich ist jedoch jede weitere Anordnung und Reihung dieser Anschlüsse denkbar.

In der Figur 1 ist im Bereich 2 des Feldbusanschlusses je eine Brückung 12 der jeweils ersten Leiter 19 und 20 der Feldbuskabel und jeweils der zweiten Leiter 19 und 20 der Feldbuskabel dargestellt. Diese Brückung 12 ermöglicht die Herstellung einer T-Stück-Funktion, bei der eine Herausnahme des Elektronikmodules 23 und damit der Schaltungselektronik des eigentlichen Feldbusanschlusses aus dem Betrieb keine weitere Beeinträchtigung der sonstigen, am Feldbus angeschlossenen Einheiten hervorruft. Hierdurch werden die zugehörigen Leiter 19, 20 der Feldbuskabel direkt miteinander verbunden, so daß der Feldbus elektrisch durchgehend bleibt. Es wird lediglich die Verbindung zum Elektronikmodul 23 selbst unterbrochen. Oberhalb des eingezeichneten Bereiches 2 des Feldbusanschlusses ist schematisch die Schaltungsanordnung 13 dargestellt, die benötigt wird, um den Feldbus in diesem Anschlußblock 1 elektrisch abzuschließen. Auch dies wird im weiteren noch ausführlicher dargestellt.

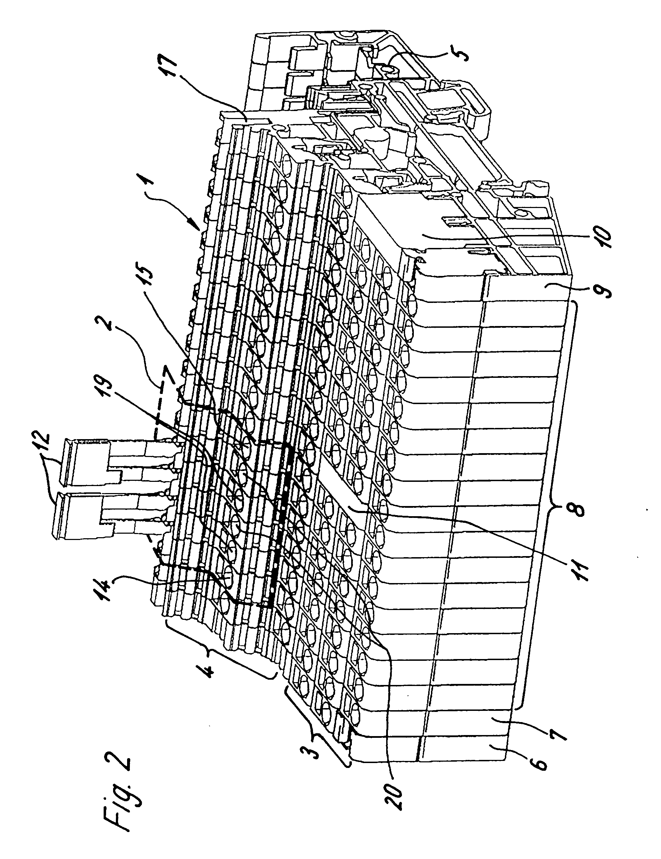

In der Figur 2 ist die prinzipielle Darstellung der Figur 1 in einer perspektivischen Ansicht eines realen Anschlußblockes 1 noch einmal verdeutlicht. Die in der Figur 2 und den Figuren 3 bis 7 aufgeführten Sachnummern entsprechen denen der Figur 1 und sind entsprechend dort schon angeführt, sie werden hier nicht erneut beschrieben.

Der Anschlußblock 1 ist in Form einer Weiterverbindungseinheit konfiguriert, in dem zwei Brückungsstecker 12 die jeweiligen ersten Leiter 19 und 20 der Feldbusanschlußkabel bzw. die jeweils zweiten Leiter 19 und 20 der Feldbusanschlußkabel kurzschließen. Hierzu ist keinerlei aktive Elektronik erforderlich, sondern nur ein leitender Kontakt zwischen den jeweils zu verbindenden Leitern 19 bzw. 20 des Feldbusanschlußkabels.

In einer bevorzugten Ausführungsform werden diese Brückungsstecker 12 eingesteckt in eine in bekannter Weise am Anschlußblock 1 vorhandene Steckplatzleiste 17, die üblicherweise für eine optionale Querverbindungsmöglichkeit zwischen den Anschlußscheiben 6-9 eines Anschlußblockes 1 vorhanden ist. Hierdurch werden weiterhin keine zusätzlichen Steckplätze erforderlich, es können darüber hinaus für die Querverbindung in Form der Brückungsstecker 12 ggf. bekannte Querverbindungsstecker genutzt werden.

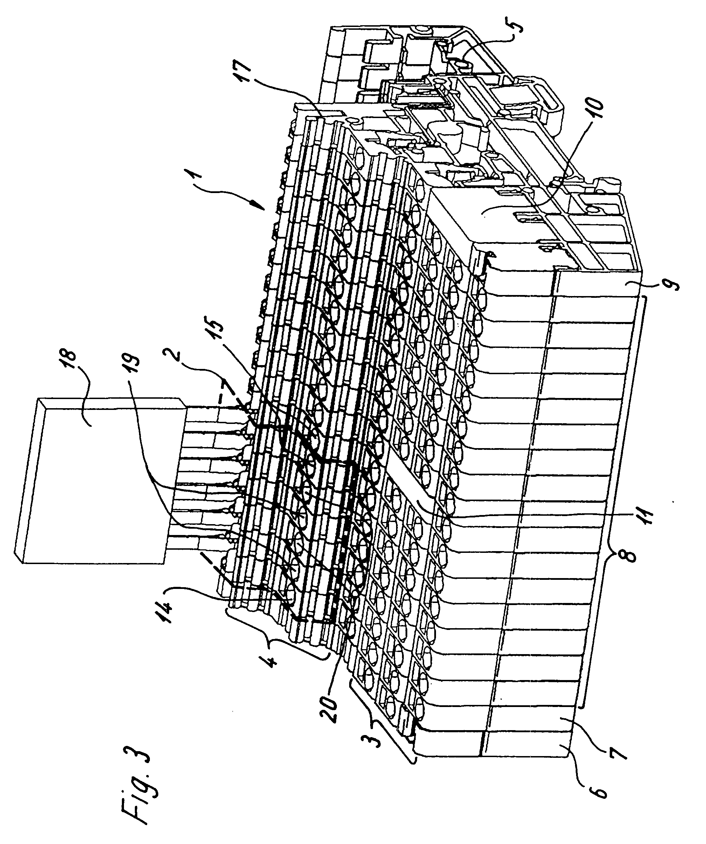

In der Figur 3, die im wesentlichen der Figur 2 entspricht, ist ebenfalls ein Anschlußblock 1 dargestellt, wobei hier die Konfiguration als Abschlußelement eines Feldbusses mittels eines Feldbusabschlußsteckers 18 dargestellt ist. Dieser Feldbusabschlußstecker 18 wird ebenfalls in der schon beschriebenen Weise in die Steckplatzleiste 17 an den jeweiligen Steckplätzen des Feldbusanschlußbereiches 2 eingesteckt.

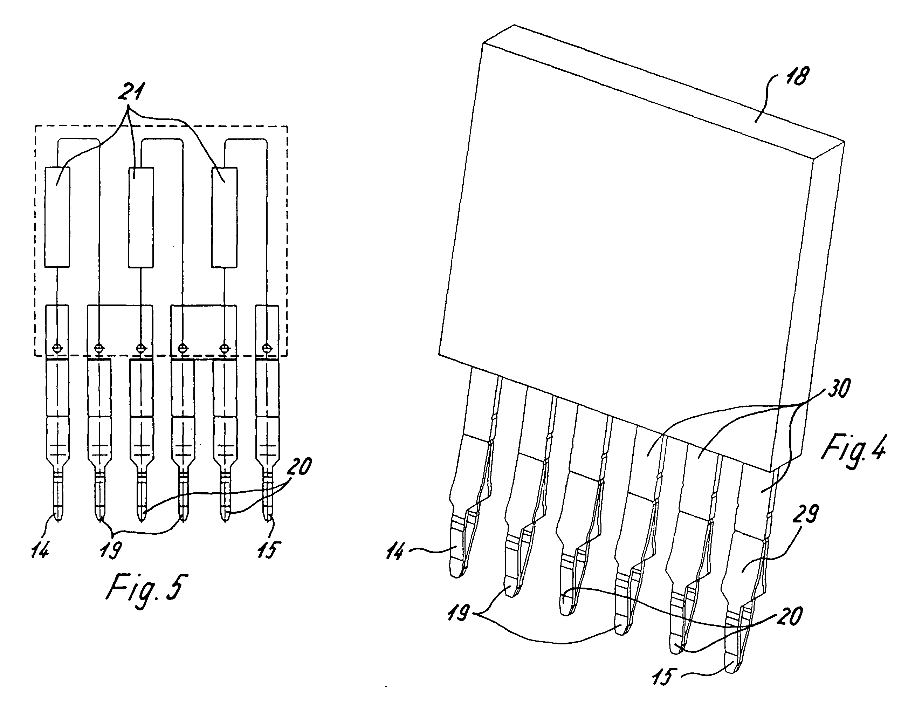

Der Feldbusabschlußstecker 18 ist in der Figur 4 noch einmal vergrößert in einer perspektivischen Ansicht dargestellt, in der man zum einen im oberen Teil in Form eines kleinen Gehäuses den Schaltungsbereich erkennt, wobei das Gehäuse gleichzeitig als Betätigungszone beim Einstecken genutzt wird. Aus dem Gehäuse ragen nach unten einzelne Kontaktzungen 30 hervor, die an ihrem steckplatzseitigen Ende in Form von Klemmfedern 29 ausgebildet sind. Diese Klemmfedern 29 stellen eine kraftschlüssige Verbindung mit den jeweiligen Gegenkontakten der Steckplatzleiste 17 her. Ebenfalls dargestellt ist die schon vorstehend genannte Belegung der Steckplätze in der bevorzugten Ausführungsform.

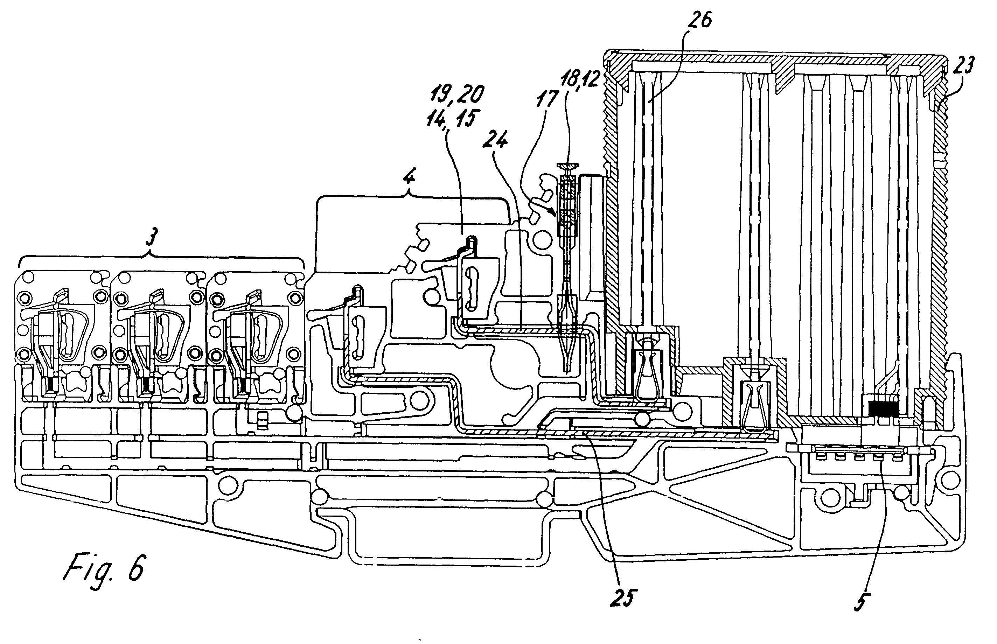

In der Figur 5 ist in einer schematischen Darstellung gezeigt, wie die elektrische Schaltungsanordnung innerhalb des Gehäuses des Feldbusabschlußsteckers 18 ausgeführt ist. Ebenfalls ist hier wiederum die erfindungsgemäß bevorzugte Ausführungsform der Steckerbelegung dargestellt. Zwischen die Spannungsversorgung 14 und den ersten Leiter 19 des ersten Feldbusanschlußkabels ist ein Widerstand 21 geschaltet, der Signalreflektionen vermeiden soll. In entsprechender Weise ist ein derartiger Widerstand 21 zwischen den ersten Leiter 20 des zweiten Feldbusanschlußkabels und den zweiten Leiter 19 des ersten Feldbusanschlußkabels geschaltet, weiterhin ein Widerstandselement 21 zwischen den zweiten Leiter 20 des zweiten Feldbusanschlußkabels und dem Bezugsleiter 15 der Spannungsversorgung. Diese Belegung der Steckkontakte innerhalb des Feldbusanschlußbereiches 2 ermöglicht es, innerhalb des Feldbusabschlußsteckers 18 eine besonders einfache Kontaktierung vorzunehmen, da nur direkt benachbarte Kontakte miteinander zu verbinden sind. Hierdurch wird es möglich, diese Kontaktierung beispielsweise in Form einer einlagigen Platine einfach und billig herzustellen. Bei anderen Anordnungen und Belegungen des Feldbusabschlußsteckers 18 wird es in der Regel erforderlich sein, nicht nur direkt nebeneinander angeordnete Kontakte miteinander zu verbinden, wodurch Kreuzungsprobleme der Verbindungen, z.B. als Leiterbahnen hervorgerufen werden können. Hierzu kann es in der in der Elektronik bekannten Weise notwendig sein, in mehr als einer Ebene derartige Kontaktierungen vorzunehmen, beispielsweise an einer mehr als einlagigen Platine, die an Ober- und Unterseite mit Leiterbahnen versehen ist.

In der Figur 6 ist eine Versorgungs-/Signalleiterscheibe dargestellt, an der man den Verteilungsbereich 3 und den Signalleiterbereich 4 erkennt. An dem dem Elektronikmodul 23 zugewandten Anschlußelement des Signalleiterbereiches 4 können je nach Funktion der Anschlußscheibe und ihrer Anordnung innerhalb des Anschlußblockes 1 die Spannungsversorgung 14 und der Bezugsleiter 15 für den Busabschluß herausgeführt werden bzw. die Leiter 19, 20 der Feldbusanschlußkabel angeschlossen werden. Von diesem Anschlußelement im Signalleiterbereich 4 verläuft ein Kontaktierungssteg 24 zum Elektronikmodul 23 und ist dort über einen Steckkontakt mit einer Platine 26 für den Feldbusanschluß verbunden. Die Signalumsetzung von und zum Feldbus erfolgt dabei vorzugsweise auf dieser Platine 26. Zwischen das Anschlußelement im Signalleiterbereich 4 und den Elektronikmodul 23 ist innerhalb der Steckplatzleiste 17 entweder der Brükkungsstecker 12 mit der T-Stück-Funktion oder der Feldbusabschlußstecker 18 einsteckbar. Hierdurch werden senkrecht zur Zeichnungsebene Verbindungen zwischen den einzelnen Kontaktierungsstegen 24 und damit zwischen den im Feldbusanschlußbereich 2 aufgelegten elektrischen Potentialen hergestellt. Ebenfalls dargestellt ist ein Kontaktierungssteg 25, der von dem anderen innerhalb des Signalleiterbereiches 4 vorhandenen Signalleiteranschlußes ebenfalls zum Elektronikmodul 23 verbunden ist.

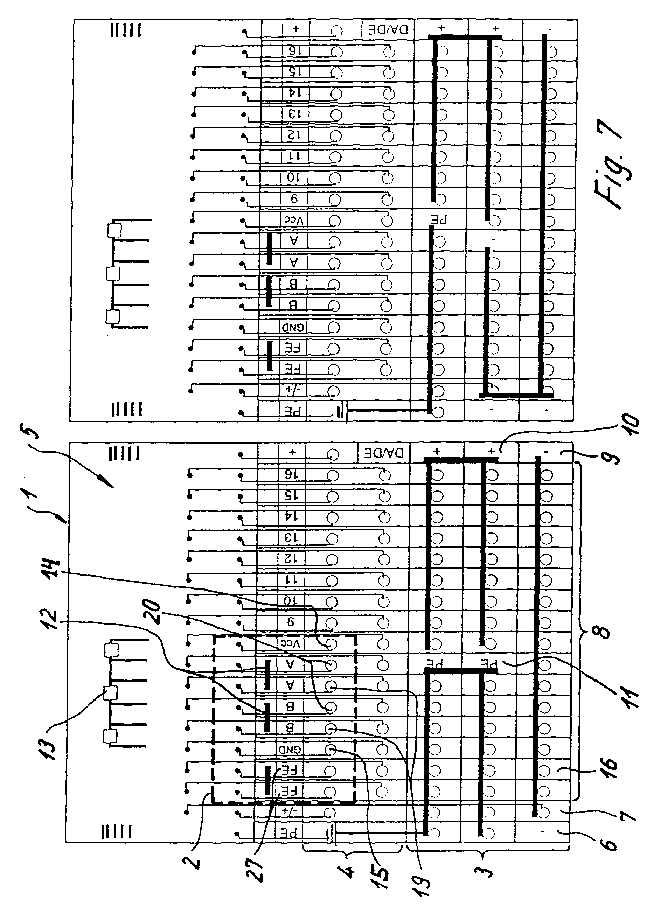

In der Figur 7 ist eine weitere Möglichkeit zur Gestaltung des Bereiches 2 zum Feldbusanschluß dargestellt, die zwei zusätzliche Anschlußelemente für eine sogen. Funktionserde 27 bietet, und die Schirmerde/Folien direkt elektrisch mit dieser kurzzuschließen. Der sonstige Aufbau des erfindungsgemäßen Anschlußblockes 1 entspricht demjenigen der Figur 1 und ist hier nicht weiter erläutert. Die Funktionserde 27 bietet für den Anwender des Anschlußblockes 1 die Möglichkeit, wahlweise eine Funktionserde 27 oder die von der Schutzleiterscheibe 6 abgreifbare Schutzerde für den Anschluß der Schirmung der Feldbusanschlußkabel zu nutzen. Eine Funktionserde 27 wird dabei vorzugsweise dann genutzt, wenn ein Potentialausgleich zwischen zwei weit voneinander entfernten Anschlußblocks 1 nicht möglich ist.

In einer anderen, nicht dargestellten Ausführungsform ist es möglich, die Schirmung der Feldbusanschlußkabel durch gesonderte Einrichtungen elektrisch zusammenzufassen und an lediglich ein Anschlußelement des mit der Schutzleiterscheibe 6 verbundenen Bereiches der Verteilerleisten anzuschließen, die die Schutzleiterfunktion aufweisen.

### Bezugszeichenliste

- 1 -: Anschlußblock
- 2 -: Feldbusanschlußbereich
- 3 -: Verteilerleisten
- 4 -: Signalleiteranschlüsse
- 5 -: Busleiter
- 6 -: Schutzleiterscheibe
- 7 -: Einspeisescheibe
- 8 -: Versorgungs-/Signalleiterscheibe
- 9 -: Rastfußscheibe
- 10 -: Brückenelement
- 11 -: Brückenelement ohne weitere Querverteilung
- 12 -: Brückungsstecker T-Stück-Funktion
- 13 -: Schaltungsanordnung Feldbusabschlußstecker
- 14 -: Spannungsversorgung
- 15 -: Bezugsleiter der Spannungsversorgung
- 16 -: Anschlußelement
- 17 -: Steckplatzleiste
- 18 -: Feldbusabschlußstecker
- 19 -: Anschlußelemente erstes Feldbuskabel
- 20 -: Anschlußelemente zweites Feldbuskabel
- 21 -: Abschlußwiderstand
- 23 -: Elektronikmodul
- 24 -: Kontaktierungssteg Feldbusanschluß
- 25 -: Kontaktierungssteg Signalleiteranschluß
- 26 -: Platine Feldbusanschluß
- 27 -: Funktionserde
- 28 -: Bereich zur Anordnung des Elektronikmoduls
- 29 -: Klemmfedern
- 30 -: Kontaktzungen

## Patentansprüche

1. Modulare Steuerungsanlage mit
- mindestens einem Anschlußblock (1) aus je einer Anzahl anreihbarer Anschlußscheiben (6-9) und darin angeordneten Versorgungsanschlüssen (3) und/oder Signalleiteranschlüs-sen (4) für zugeordnete Initiatoren, Aktoren, Feldgeräte,
- einem Elektronikmodul (23) zur Signalver- und
- bearbeitung, als Verbindung zwischen den Signalleiteranschlüssen (4) und einem internen Busleiter (5) sowie mit einer integrierten Signalanpassung für einen Feldbus,
**dadurch gekennzeichnet, dass**
Signalleiteranschlüsse (4) des Anschlußblockes (1) für den Anschluß mindestens eines Feldbuskabels genutzt werden, wobei die Steuerungsanlage weiterhin mit diesen Signalleiteranschlüssen (4) zugeordneten Steckplätzen, in denen funktionsverschiedene Verbindungselemente (12, 18) einsteckbar sind, versehen ist, wobei die Verbindungselemente (12, 18) je nach Einordnung des Anschlußblocks (1) in den Feldbus elektrische Potentiale von Feldbuskabel und Anschlußblock (1) als Abschlußeinheit (18) oder als Weiterverbindungseinheit (12) miteinander verbinden.

2. Modulare Steuerungsanlage nach Anspruch 1, **dadurch gekennzeichnet, daß** in den Verbindungselementen die elektrischen Potentiale Funktionserde (27), Spannungsversorgung (14), zwei Leiter eines einkommenden, ersten Feldbuskabels (19), zwei Leiter eines herausgehenden, zweiten Feldbuskabels (20) sowie ein Bezugsleiter (15) der Spannungsversorgung miteinander verbindbar sind.

3. Modulare Steuerungsanlage nach einem der Ansprüche 1 oder 2, **dadurch gekennzeichnet, daß** die Abschlußeinheit (18) zum elektrischen Abschluß eines Feldbuskabels eine Anzahl von Widerstandselementen (21) aufweist.

4. Modulare Steuerungsanlage nach Anspruch 3, **dadurch gekennzeichnet, daß** eine Abschlußeinheit (18) Widerstandselemente (21) jeweils zwischen
- Spannungsversorgung (14) und einem ersten Leiter (19) des ersten Feldbuskabels,
- einem ersten Leiter (20) des zweiten Feldbuskabels und einem zweiten Leiter (19) des ersten Feldbuskabels,
- einem zweiten Leiter (20) des zweiten Feldbuskabels und dem Bezugsleiter (15)
enthält, wobei jeweils
- der erste Leiter (19) des ersten Feldbuskabels und der erste Leiter (20) des zweiten Feldbuskabels,
- der zweite Leiter (19) des ersten Feldbuskabels und der zweite Leiter (20) des zweiten Feldbuskabels
direkt miteinander verbunden sind.

5. Modulare Steuerungsanlage nach Anspruch 3, **dadurch gekennzeichnet, daß** eine Abschlußeinheit (18) Widerstandselemente (21) jeweils zwischen
- Spannungsversorgung (14) und einem ersten Leiter (19) des ersten Feldbuskabels,
- einem ersten Leiter (20) des zweiten Feldbuskabels und einem zweiten Leiter (19) des ersten Feldbuskabels,
- einem zweiten Leiter (20) des zweiten Feldbuskabels und dem Bezugsleiter (15)
enthält, wobei jeweils
- der erste Leiter (19) des ersten Feldbuskabels und der erste Leiter (20) des zweiten Feldbuskabels,
- der zweite Leiter (19) des ersten Feldbuskabels und der zweite Leiter (20) des zweiten Feldbuskabels
- die Anschlußmöglichkeiten für die Funktionserde (27)
direkt mineinander verbunden sind.

6. Modulare Steuerungsanlage nach einem der Ansprüche 1 oder 2, **dadurch gekennzeichnet, daß** eine Weiterverbindungseinheit (12) eine T-stückartige Verbindung zwischen
- dem ersten Leiter (19) des ersten Feldbuskabels und dem ersten Leiter (20) des zweiten Feldbuskabels,
- dem zweiten Leiter (19) des ersten Feldbuskabels und dem zweiten Leiter (20) des zweiten Feldbuskabels,
- dem Elektronikmodul (23)
aufweist.

7. Modulare Steuerungsanlage nach einem der Ansprüche 1 oder 2, **dadurch gekennzeichnet, daß** die Anschlüsse von Versorgungsspannung (14) und Bezugsleiter (15) des Feldbusabschlusses an den Verteilungsbereich des Anschlußblocks (1) anschließbar sind.

8. Modulare Steuerungsanlage nach einem der Ansprüche 1 oder 2, **dadurch gekennzeichnet, daß** die Anschlüsse von Versorgungsspannung (14) und Bezugsleiter (15) des Feldbusabschlusses aus dem Elektronikmodul kommend herausgeführt werden.

9. Modulare Steuerungsanlage nach einem der vorstehenden Ansprüche, **dadurch gekennzeichnet, daß** mit den Verbindungselementen (12, 18) verbindbare Potentiale derart den Steckplätzen (17) zugeordnet sind, daß alle Verbindungselemente (12, 18) in einer Ebene angeordnet sind.

10. Modulare Steuerungsanlage nach Anspruch 9, **dadurch gekennzeichnet, daß** die mit den Verbindungelementen (12, 18) verbindbare Potentiale in der Reihenfolge Spannungsversorgung (14), erster Leiter (19) des ersten Feldbuskabels, erster Leiter (20) des zweiten Feldbuskabels, zweiter Leiter (19) des ersten Feldbuskabels, zweiter Leiter (20) des zweiten Feldbuskabels, Bezugsleiter (15) angeordnet sind.

11. Modulare Steuerungsanlage nach Anspruch 9, **dadurch gekennzeichnet, daß** die mit den Verbindungselementen (12, 18) verbindbare Potentiale in der Reihenfolge einseitig der Steckplätze des Feldbusanschlusses (2) mindestens eine Funktionserde (27), daran anschließend Spannungsversorgung (14), erster Leiter (19) des ersten Feldbuskabels, erster Leiter (20) des zweiten Feldbuskabels, zweiter Leiter (19) des ersten Feldbuskabels, zweiter Leiter (20) des zweiten Feldbuskabels, Bezugsleiter (15) angeordnet sind.

12. Modulare Steuerungsanlage nach einem der vorstehenden Ansprüche 1 bis 8, **dadurch gekennzeichnet, daß** mit den Verbindungelementen (12, 18) verbindbare Potentiale derart den Steckplätzen (17) zugeordnet sind, daß Verbindungselemente (12, 18) in mehr als einer Ebene angeordnet sind.

13. Modulare Steuerungsanlage nach einem der vorstehenden Ansprüche, **dadurch gekennzeichnet, daß** an allen Anschlußscheiben (6-9) vorhandene, bekannte Querverteilersteckplätze als Einsteckplätze (17) nutzbar sind.

14. Modulare Steuerungsanlage nach einem der vorstehenden Ansprüche, **dadurch gekennzeichnet, daß** bei einer Anreihung mittels internem Busleiter (5) gekoppelter Anschlußblocks (1) nur ein Feldbusanschluß für jede Anreihung vorsehbar ist.

15. Modulare Steuerungsanlage nach einem der vorstehenden Ansprüche, **dadurch gekennzeichnet, daß** die Schirmungen von mehr als einem Feldbusanschlußkabel elektrisch miteinander und mit dem Anschlußblock (1) verbindbar sind.

16. Modulare Steuerungsanlage nach einem der vorstehenden Ansprüche, **dadurch gekennzeichnet, daß** die Schirmung des mindestens einen Feldbusanschlußkabels wahlweise mit einer Funktionserde (27) oder mit einem dem Schutzleiterscheibe (6) verbindbar ist.

17. Modulare Steuerungsanlage nach einem der vorstehenden Ansprüche, **dadurch gekennzeichnet, daß** Anordnung und Verbindung von Anschlußelementen und Querverteilerleisten im Verteilerbereich (3) des Anschlußblocks (1) veränderbar ist, wobei auch Brückenelemente (10, 11) und Trennelemente verwendbar sind.

18. Modulare Steuerungsanlage nach einem der vorstehenden Ansprüche, **dadurch gekennzeichnet, daß** in einem Anschlußblock (1) eine Anzahl von Eingangs- und von Ausgangsbaugruppen für zugeordnete Initiatoren, Aktoren, Feldgeräte oder dgl. angeordnet sind.

## Claims

1. Modular control system having
- at least one connecting block (1), in each case comprising a number of connecting discs (6-9), which can be arranged in a row, and supply connections (3), which are arranged in them, and/or signal conductor connections (4) for associated initiators, actuators and field devices,
- an electronics module (23) for signal processing, as a connection between the signal conductor connections (4) and an internal bus conductor (5), and having integrated signal matching for a fieldbus,
**characterized in that**
signal conductor connections (4) of the connecting block (1) are used for the connection of at least one fieldbus cable,
with the control system furthermore being provided with plug-in slots which are associated with these signal conductor connections (4) and in which connection elements (12, 18) having various functions can be inserted, and, depending on the arrangement of the connecting block (1) in the fieldbus, the connection elements (12, 18) connecting electrical potentials on the fieldbus cable and connection block (1) to one another, as a termination unit (18) or as a further-connection unit (12).

2. Modular control system according to Claim 1, **characterized in that** the electrical potentials of the function earth (27), voltage supply (14), two conductors of an incoming, first fieldbus cable (19), two conductors of an outgoing, second fieldbus cable (20) and a reference-earth conductor (15) of the voltage supply can be connected to one another in the connection elements.

3. Modular control system according to one of Claims 1 or 2, **characterized in that** the termination unit (18) has a number of resistance elements (21) for electrical termination of a fieldbus cable.

4. Modular control system according to Claim 3, **characterized in that** a termination unit (18) in each case contains resistance elements (21) between
- the voltage supply (14) and a first conductor (19) of the first fieldbus cable,
- a first conductor (20) of the second fieldbus cable and a second conductor (19) of the first fieldbus cable,
- a second conductor (20) of the second fieldbus cable and the reference-earth conductor (15),
with
- the first conductor (19) of the -first fieldbus cable and the first conductor (20) of the second fieldbus cable, and
- the second conductor (19) of the first fieldbus cable and the second conductor (20) of the second fieldbus cable
being directly connected to one another.

5. Modular control system according to Claim 3, **characterized in that** a termination unit (18) in each case contains resistance elements (21) between
- the voltage supply (14) and a first conductor (19) of the first fieldbus cable,
- a first conductor (20) of the second fieldbus cable and a second conductor (19) of the first fieldbus cable,
- a second conductor (20) of the second fieldbus cable and the reference-earth conductor (15),
with
- the first conductor (19) of the first fieldbus cable and the first conductor (20) of the second fieldbus cable,
- the second conductor (19) of the first fieldbus cable and the second conductor (20) of the second fieldbus cable, and
- the connection options for the function earth (27)
being directly connected to one another.

6. Modular control system according to one of Claims 1 or 2, **characterized in that** a further connection unit (12) has a connection like a T-piece between
- the first conductor (19) of the first fieldbus cable and the first conductor (20) of the second fieldbus cable,
- the second conductor (19) of the first fieldbus cable and the second conductor (20) of the second fieldbus cable, and
- the electronics module (23).

7. Modular control system according to one of Claims 1 or 2, **characterized in that** the connections of the supply voltage (14) and of the reference-earth conductor (15) of the fieldbus termination can be connected to the distribution area of the connecting block (1).

8. Modular control system according to one of Claims 1 or 2, **characterized in that** the connections of the supply voltage (14) and of the reference-earth conductor (15) of the fieldbus termination are routed out of the electronics module.

9. Modular control system according to one of the preceding claims, **characterized in that** potentials which can be connected to the connection elements (12, 18) are associated with the plug-in slots (17) in such a manner that all the connection elements (12, 18) are arranged in one plane.

10. Modular control system according to Claim 9,
**characterized in that** the potentials which can be connected to the connection elements (12, 18) are arranged in the sequence voltage supply (14), first conductor (19) of the first fieldbus cable, first conductor (20) of the second fieldbus cable, second conductor (19) of the first fieldbus cable, second conductor (20) of the second fieldbus cable, and reference-earth conductor (15).

11. Modular control system according to Claim 9, **characterized in that** the potentials which can be connected to the connection elements (12, 18) are arranged on one side of the plug-in slots of the fieldbus connection (2) in the sequence at least one function earth (27), then followed by the voltage supply (14), first conductor (19) of the first fieldbus cable, first conductor (20) of the second fieldbus cable, second conductor (19) of the first fieldbus cable, second conductor (20) of the second fieldbus cable, and reference-earth conductor (15).

12. Modular control system according to one of the preceding Claims 1 to 8, **characterized in that** potentials which can be connected to the connection elements (12, 18) are associated with the plug-in slots (17) in such a manner that connection elements (12, 18) are arranged in more than one plane.

13. Modular control system according to one of the preceding claims, **characterized in that** known cross-distribution plug-in slots, which are provided on all the connecting discs (6-9), can be used as plug-in slots (17).

14. Modular control system according to one of the preceding claims, **characterized in that** when connecting blocks (1) which are coupled by means of an internal bus conductor (5) are arranged in rows, only one fieldbus connection can be provided for each row.

15. Modular control system according to one of the preceding claims, **characterized in that** the screens of more than one fieldbus connecting cable can be electrically connected to one another and to the connecting block (1).

16. Modular control system according to one of the preceding claims, **characterized in that** the screen of the at least one fieldbus connecting cable can optionally be connected to a function earth (27) or to a protective-earth conductor disc (6).

17. Modular control system according to one of the preceding claims, **characterized in that** the arrangement and connection of connecting elements and cross-distribution strips in the distribution area (3) of the connecting block (1) can be varied, and bridging elements (10, 11) and separating elements can also be used.

18. Modular control system according to one of the preceding claims, **characterized in that** a number of input assemblies and output assemblies for associated initiators, actuators, field devices or the like are arranged in one connecting block (1).

## Revendications

1. Installation de commande modulaire comportant :
- au moins un bloc de jonction (1) constitué d'un certain nombre de plaques de jonction (6 à 9) pouvant être alignés et de bornes d'alimentation (3) disposées à l'intérieur et/ou de bornes de ligne de signal (4) pour des initiateurs, effecteurs, appareils inducteurs associés,
- un module électronique (23) pour le traitement des signaux, en tant que liaison entre les bornes de ligne de signal (4) et une ligne de bus (5) interne, ainsi qu'une adaptation de signal intégrée pour un bus de champ,
**caractérisée en ce que**
des bornes de ligne de signal (4) du bloc de jonction (1) sont utilisées pour la connexion d'au moins un câble de bus de champ, l'installation de commande comportant en outre des emplacements pour enfichage, associés à ces bornes de ligne de signal (4), dans lesquels des éléments de liaison (12, 18) aux fonctions différentes peuvent être enfichés, des éléments de liaison (12, 18) reliant entre eux, suivant le rangement du bloc de jonction (1) dans le bus de champ, des potentiels électriques de câbles de bus de champ et du bloc de jonction (1), en tant qu'unité terminale (18), ou en tant qu'unité de transfert (12).

2. Installation de commande modulaire selon la revendication 1, **caractérisée en ce que** dans les éléments de liaison, les potentiels électriques : terre fonctionnelle (27), alimentation en tension (14), deux lignes d'un premier câble de bus de champ (19) entrant, deux lignes d'un deuxième câble de bus de champ (20) sortant, ainsi qu'une ligne de référence (15) de l'alimentation en tension, peuvent être reliés entre eux.

3. Installation de commande modulaire selon l'une des revendications 1 ou 2, **caractérisée en ce que** l'unité terminale (18) comporte un certain nombre d'éléments à résistance (21), pour la terminaison électrique d'un câble de bus de champ.

4. Installation de commande modulaire selon la revendication 3, **caractérisée en ce qu'**une unité terminale (18) contient des éléments à résistance (21), chacun entre
- l'alimentation en tension (14) et une première ligne (19) du premier câble de bus de champ,
- une première ligne (20) du deuxième câble de bus de champ et une deuxième ligne (19) du premier câble de bus de champ,
- une deuxième ligne (20) du deuxième câble de bus de champ et la ligne de référence (15),
tandis que
- la première ligne (19) du premier câble de bus de champ et la première ligne (20) du deuxième câble de bus de champ,
- la deuxième ligne (19) du premier câble de bus de champ et la deuxième ligne (20) du deuxième câble de bus de champ
sont directement reliées entre elles.

5. Installation de commande modulaire selon la revendication 3, **caractérisée en ce qu'**une unité terminale (18) contient des éléments de résistance (21), chacun entre
- l'alimentation en tension (14) et une première ligne (19) du premier câble de bus de champ,
- une première ligne (20) du deuxième câble de bus de champ et une deuxième ligne (19) du premier câble de bus de champ,
- une deuxième ligne (20) du deuxième câble de bus de champ et la ligne de référence (15),
tandis que
- la première ligne (19) du premier câble de bus de champ et la première ligne (20) du deuxième câble de bus de champ,
- la deuxième ligne (19) du premier câble de bus de champ et la deuxième ligne (20) du deuxième câble de bus de champ,
- les possibilités de connexion pour la terre fonctionnelle (27)
sont directement reliées entre elles.

6. Installation de commande modulaire selon l'une des revendications 1 ou 2, **caractérisée en ce qu'**une unité de transfert (12) comporte une liaison en T entre :
- la première ligne (19) du premier câble de bus de champ et la première ligne (20) du deuxième câble de bus de champ,
- la deuxième ligne (19) du premier câble de bus de champ et la deuxième ligne (20) du deuxième câble de bus de champ,
- le module électronique (23).

7. Installation de commande modulaire selon l'une des revendications 1 ou 2, **caractérisée en ce que** les bornes de la tension d'alimentation (14) et de la ligne de référence (15) de la terminaison de bus de champ peuvent être connectées à la zone de distribution du bloc de jonction (1).

8. Installation de commande modulaire selon l'une des revendications 1 ou 2, **caractérisée en ce que** les bornes de la tension d'alimentation (14) et de la ligne de référence (15) de la terminaison du bus de champ peuvent être ressorties du module électronique.

9. Installation de commande modulaire selon l'une des revendications précédentes, **caractérisée en ce que** des potentiels, qui peuvent être reliés aux éléments de liaison (12, 18), sont affectés aux emplacements pour enfichage (17) de manière que tous les éléments de liaison (12, 18) soient disposés dans un plan.

10. Installation de commande modulaire selon la revendication 9, **caractérisée en ce que** les potentiels, qui peuvent être reliés aux éléments de liaison (12, 18), sont disposés dans l'ordre suivant: alimentation en tension (14), première ligne (19) du premier câble de bus de champ, première ligne (20) du deuxième câble de bus de champ, deuxième ligne (19) du premier câble de bus de champ, deuxième ligne (20) du deuxième câble de bus de champ, ligne de référence (15).

11. Installation de commande modulaire selon la revendication 9, **caractérisée en ce que** les potentiels, qui peuvent être reliés aux éléments de liaison (12, 18), sont disposés sur un côté des emplacements pour enfichage de la borne de bus de champ (2), dans l'ordre suivant: au moins une terre fonctionnelle (27), à la suite de celle-ci l'alimentation en tension (14), la première ligne (19) du premier câble de bus de champ, la première ligne (20) du deuxième câble de bus de champ, la deuxième ligne (19) du premier câble de bus de champ, la deuxième ligne (20) du deuxième câble de bus de champ, la ligne de référence (15).

12. Installation de commande modulaire selon l'une des revendications précédentes 1 à 8, **caractérisée en ce que** des potentiels, qui peuvent être reliés aux éléments de liaison (12, 18), sont affectés aux emplacements pour enfichage (17) de manière que des éléments de liaison (12, 18) soient disposés dans plus d'un plan.

13. Installation de commande modulaire selon l'une des revendications précédentes, **caractérisée en ce que** l'on peut utiliser, sur toutes les plaques de jonction (6 à 9), des emplacements pour enfichage de distribution transversale existants et connus, comme emplacements pour enfichage (17).

14. Installation de commande modulaire selon l'une des revendications précédentes, **caractérisée en ce que** dans le cas d'un alignement de blocs de jonction (1), accouplés au moyen d'une ligne de bus (5) interne, on peut ne prévoir qu'une borne de bus de champ pour chaque alignement.

15. Installation de commande modulaire selon l'une des revendications précédentes, **caractérisée en ce que** les blindages de plus d'un câble de connexion de bus de champ, peuvent être reliés électriquement entre eux et au bloc de jonction (1).

16. Installation de commande modulaire selon l'une des revendications précédentes, **caractérisée en ce que** le blindage du ou des câbles de connexion de bus de champ, peut être relié au choix à une terre fonctionnelle (27) ou à une plaque de conducteur de protection (6).

17. Installation de commande modulaire selon l'une des revendications précédentes, **caractérisée en ce que** la disposition et la liaison d'éléments de connexion et de baguettes de distribution transversale, dans la zone de distribution (3) du bloc de jonction (1), sont variables, des éléments de pontage (10, 11) et des éléments de sectionnement pouvant être utilisés aussi.

18. Installation de commande modulaire selon l'une des revendications précédentes, **caractérisée en ce que** sont disposés, dans un bloc de jonction (1), un certain nombre de groupes d'entrée et de groupes de sortie pour des initiateurs, effecteurs, appareils inducteurs ou similaires associés.
